# EUROPÄISCHE PATENTSCHRIFT

(11) **EP 3 561 525 B1**
(45) Veröffentlichungstag und Bekanntmachung des Hinweises auf die Patenterteilung: **08.12.2021**
(21) Anmeldenummer: 18169731.9
(22) Anmeldetag: 27.04.2018
(51) Int. Cl.: G01R 15/20, G01R 33/00, G01R 33/025

(54) **MAGNETISCHE SCHIRMUNG EINES SENSORS MIT INNENLIEGENDEM STÖRFELD**
MAGNETIC SHIELDING OF A SENSOR WITH INTERNAL INTERFERING FIELD
BLINDAGE MAGNÉTIQUE D'UN CAPTEUR À CHAMP PARASITES INTERNE

(43) Veröffentlichungstag der Anmeldung: 30.10.2019
(73) Patentinhaber: Baumer Electric AG, 8500 Frauenfeld (CH)
(72) Erfinder: Hohl, Michael, 8405 Winterthur (CH); Sperling, Tilo, 78333 Stockach (DE)
(74) Vertreter: Strauss, Steffen

(56) Entgegenhaltungen:
- EP-A1- 2 843 424
- EP-A2- 2 355 265
- EP-A2- 2 530 475
- WO-A1-94/27157
- DE-A1- 10 104 453
- DE-A1-102013 112 628
- JP-A- 2007 113 965
- JP-A- 2010 078 537
- KR-B1- 101 776 774
- US-A- 5 473 244
- US-A1- 2006 028 195
- US-A1- 2015 260 762

## Beschreibung

### Elektrische Baueinheit mit Abschirmung magnetischer Felder

Die Erfindung betrifft eine elektrische Baueinheit nach dem Oberbegriff des Anspruchs 1.

Aus dem Stand der Technik ist beispielsweise aus der DE 10 2012 220 139 A1 eine magnetische Messanordnung zur Bewegungserfassung eines bewegten Bauteils bekannt, welche ein Abschirmelement aufweist, um das zur Bewegungserfassung vorgesehene Sensorelement der Messanordnung vor störenden Magnetfeldern zu schützen.

Die JP 2007 113 965 A offenbart einen Stromsensor zur Messung eines durch eine Strompfad fließenden Stroms. Dabei wird das Magnetfeld, welches durch den fließenden Strom erzeugt wird, für die Messung des Stromwertes genutzt.

Aufgabe der Erfindung ist es, eine elektrische Baueinheit mit einer Sensorvorrichtung bereitstellen zu können, welche eine besonders effektive Abschirmung der Sensorvorrichtung vor Magnetfeldern ermöglicht.

Die Aufgabe wird, ausgehend von einer elektrischen Baueinheit der eingangs genannten Art, durch die kennzeichnenden Merkmale des Anspruchs 1 gelöst.

Durch die in den abhängigen Ansprüchen genannten Maßnahmen sind vorteilhafte Ausführungen und Weiterbildungen der Erfindung möglich.

Die erfindungsgemäße elektrische Baueinheit umfasst zunächst eine Sensorvorrichtung zur sensorischen Erfassung einer Messgröße und verwendet des Weiteren einen Sensorkopf zur Erfassung einer magnetischen bzw. elektrischen Messgröße. Darüber hinaus ist eine Abschirmvorrichtung vorgesehen, um die Sensorvorrichtung vor einem Magnetfeld, das in Bezug auf die Sensorvorrichtung als Störfeld wirkt, abzuschirmen.

Der Begriff Sensorkopf bezeichnet im Sinne der Erfindung insbesondere den eigentlichen Sensor bzw. den Teil der Sensorvorrichtung, der die eigentliche sensorische Erfassung bzw. Messung der zu bestimmenden Messgröße durchführt, zumindest jedoch den Teil, der vom Störfeld abgeschirmt werden soll.

In verschiedenen Bereichen der Technik bildet die Zusammenfassung verschiedener funktionaler Einheiten in einer Baueinheit eine zentrale Aufgabenstellung. Beispielsweise ist es im Bereich der Eisenbahntechnik von Vorteil, eine Baueinheit zur Verfügung zu stellen, die sowohl einen Drehgeber zur Bestimmung der Geschwindigkeit als auch die Erdbürste bzw. einen mit der Erdbürste verbindbaren Leiter, mit dem Strom während der Fahrt in die Schiene geleitet werden kann, umfasst. Ein Drehgeber erfasst in diesem Fall ein mit einem Rotor sich ständig veränderndes Magnetfeld und ist somit potentiell störanfällig in Bezug auf externe Magnetfelder. Über die Erdbürste zum Beispiel werden jedoch relativ hohe Ströme geführt (etwa im Bereich von 1500 A), sodass diese wiederum ein relativ hohes Magnetfeld erzeugen können. Ein gerader, stromdurchflossener Leiter erzeugt ein Magnetfeld mit kreisförmigen, konzentrischen Feldlinien, die senkrecht zur Stromrichtung im Leiter ausgerichtet sind. Ein solcher Leiter ist entsprechend von geschlossenen Magnetfeldlinien umgeben, die jedoch nicht ohne weiteres abgeschirmt werden können. Würde der Leiter zum Beispiel gemäß dem Stand der Technik von einem magnetisch leitfähigen Material umschlossen werden, würde dies keine hinreichende Abschirmwirkung erzielen können.

Bei einer herkömmlichen Abschirmung, wie sie beispielsweise aus der DE 10 2012 220 139 A1 bekannt ist, wird vorgeschlagen, ein in sich geschlossenes Abschirmungselement, etwa in Form eines Rahmens, zu verwenden. Zur vereinfachten Fixierung werden diese Abschirmelemente aus dem Stand der Technik in vorgegebenen Aussparungen eines Gehäuses klemmend fixiert, wobei die Abschirmelemente einen größeren Durchmesser als die Aussparung aufweisen und somit zunächst zusammengedrückt und dann in die Aussparung eingebracht werden. In der Aussparung weiten sie sich wieder und drücken gegen die Innenwand der Aussparung, sodass eine Klemmung zustande kommt.

Dementsprechend zeichnet sich die erfindungsgemäße elektrische Baueinheit dadurch aus, dass die Abschirmvorrichtung ein als Rahmen bzw. Hohlkörper ausgebildetes Abschirmelement aus einem magnetisch leitfähigen Material umfasst, das den wenigstens einen elektrischen Leiter wenigstens auf einem Teil der Länge, insbesondere über die gesamte Länge des wenigstens einen elektrischen Leiters in einer Ebene senkrecht zur Stromflussrichtung bis auf ein Unterbrechungsspalt umgibt, um das Störfeld zu verzerren und/oder zu verschieben. Die Erfindung verhindert somit in vorteilhafter Weise, dass sich geschlossene Feldlinien allein in dem Abschirmelement um den Leiter herum ausbilden bzw. konzentrieren. Die Feldlinien durchlaufen zwar einen Teil des Abschirmelements, treten in Richtung zum Unterbrechungsspalt hin jedoch wieder aus. Durch diesen Unterbrechungsspalt verzerrt sich folglich das Magnetfeld und verschiebt sein Zentrum gewissermaßen in Richtung Unterbrechungsspalt, d.h. im Wesentlichen umgeben die Feldlinien nunmehr auch den Unterbrechungsspalt und das Zentrum des Magnetfelds wird in Richtung des Unterbrechungsspalts gewissermaßen verschoben.

Das als Rahmen bzw. Hohlkörper ausgebildete Abschirmelement kann somit z.B. zylindrisch ausgebildet sein, was auch die Herstellung erleichtert.

Der Unterbrechungsspalt ist im Allgemeinen klein in Bezug auf den gesamten, den Leiter umgebenden Winkelbereich ausgebildet. Dieser Winkelbereich ist in der Regel kleiner als 30°, insbesondere kleiner als 20°, vorzugsweise kleiner als 10° in seinem Winkelbereich in Bezug auf den Leiter im Ursprung ausgebildet.

Bei dem wenigstens einen elektrischen Leiter kann es sich auch um eine Schaltung oder einen Teil einer elektrischen Schaltung handeln, welche/welcher ein magnetisches Störfeld erzeugt, vor dem ein Sensor der Baueinheit abgeschirmt werden soll.

Durch diese, durch das Abschirmelement mit Spalt erzeugte Verzerrung wird das Störfeld in bestimmten Raumbereichen lokal geschwächt, sodass sich grundsätzlich diese Positionen, an denen Minima des Magnetfeldes auftreten, grundsätzlich bei einer Ausführungsform der Erfindung sehr gut dazu eignen, um an dieser Stelle einen Sensor bzw. einen Sensorkopf zu platzieren und somit die Störung durch das Magnetfeld möglichst stark zu verringern.

Das Abschirmelement selbst ist aus einem magnetisch leitfähigen Material ausgebildet, zum Beispiel aus einem Ferromagneten. Um die Abschirmung weiter zu optimieren, kann der Leiter innerhalb der elektrischen Baueinheit auf seiner gesamten Länge abgeschirmt werden, indem das Abschirmelement den Leiter auf seiner gesamten Länge im gesamten Winkelbereich bis auf den Unterbrechungsspalt umgibt. Es ist aber auch denkbar, den elektrischen Leiter innerhalb der Baueinheit nur auf einer bestimmten Länge hin abzuschirmen, sofern diese Maßnahme zum Beispiel ausreicht, um den Sensorkopf damit hinreichend zu schirmen.

In besonders vorteilhafter Weise greift die Erfindung gerade auch das technische Problem auf, von elektrischen Leitern hervorgerufene Magnetfelder abzuschirmen, die um sich herum außerhalb des elektrischen Leiters geschlossene Magnetfeldlinien erzeugen, und geht somit weiter als die Abschirmung von Magnetfeldern, die durch Permanentmagneten erzeugt werden, bei denen wiederum die Feldlinien abschnittsweise durch das Material des Permanentmagneten selbst verlaufen.

Wenn die Sensorvorrichtung selbst ein Magnetfeld, nämlich ein vom Störfeld verschiedenes und unabhängiges Nutzfeld, detektieren soll, kann die Sensorvorrichtung in der Regel nicht vollständig nach außen hin abgeschirmt werden, sondern sie muss im Raumbereich des Nutzfeldes liegen. Zumindest kann die Sensorvorrichtung nicht vor der Quelle des Nutzfeldes abgeschirmt werden.

Erfindungsgemäß ist die Sensorvorrichtung und der Sensorkopf im Bereich eines Minimums der magnetischen Feldstärke bzw. Flussdichte des durch die Abschirmvorrichtung verzerrten bzw. verschobenen Störfelds angeordnet, und zwar auf der dem Unterbrechungsspalt abgewandten Seite. Allgemeiner formuliert kann der Sensorkopf bzw. die Sensorvorrichtung in Bezug zum Abschirmelement, das den Unterbrechungsspalt aufweist, auf der dem Zentrum des verzerrten Störfeldes abgewandten Seite angeordnet werden. Dadurch wird die Verzerrung des Magnetfeldes dazu verwendet, um die Störung der Sensorvorrichtung durch magnetische Einflüsse möglichst gering zu halten. Es ist auch denkbar, dass ein Teil der Sensorvorrichtung, der nicht oder zumindest nicht wesentlich durch ein Magnetfeld beeinflussbar ist, an einer anderen Stelle außerhalb eines eigentlichen Minimums im Magnetfeld oder außerhalb des dem Unterbrechungsspalt abgewandten Teils angeordnet wird, zumal je nach Ausführungsform die gesamte Sensorvorrichtung z.B. einschließlich einer signalverarbeitenden Elektronik auch einen entsprechenden Bauraum benötigt. In der Regel ist vor allem der messempfindliche Sensorkopf abzuschirmen, sodass zumindest dieser Bereich an einem Minimum der magnetischen Flussdichte bzw. im Bereich des dem Unterbrechungsspalt abgewandten teils angeordnet werden kann.

Um das Abschirmungsergebnis noch weiter zu verbessern, kann die Abschirmvorrichtung bei einer Weiterbildung der Erfindung wenigstens ein Zusatz-Abschirmelement umfassen, also zusätzlich zum als Rahmen bzw. Hohlkörper ausgebildeten Abschirmelement, das den Leiter umgibt und einen Unterbrechungsspalt aufweist. Zusatz-Abschirmelemente kommen im Allgemeinen verschiedene Formen aufweisen. Zum Beispiel eignen sich hierfür als Platte oder als im Wesentlichen eben ausgebildete Abschirmelemente. Eine solche Platte kann ebenfalls das Magnetfeld sehr gut abschirmen, denn auf der dem elektrischen Leiter als Erzeuger des Störfelds abgewandten Seite der Platte liegt ein Bereich eines lokalen Minimums der Feldstärke.

Denkbar ist auch, dass bei einer Ausführungsform der Erfindung ein topfförmiges Abschirmelement verwendet wird. Eine Sensorvorrichtung bzw. ein Sensorkopf kann sodann insbesondere im Inneren des topförmigen Abschirmelementes angeordnet werden, also in einem Bereich, der in wenigstens einer Ebene von diesem Abschirmelement umgeben wird und zu einer Seite hin wenigstens teilweise insbesondere vollständig vom Abschirmelement abgegrenzt wird. Durch ein topfförmiges Zusatz-Abschirmelement kann das magnetische Störfeld auch seitlich, d.h. nicht in direkter Verbindungslinie zum Leiter abgeschirmt werden. Darüber hinaus kann ein solches Element auch gegen andere äußere Störfelder schirmen.

Bei einer besonders bevorzugten Ausführungsform der Erfindung sind beide zuvor genannten Formen von Abschirmelementen, nämlich eines in Form einer Platte bzw. eines ebenen Elements und das eines topförmigen Elementes als Zusatz-Abschirmelemente vorgesehen. Durch eine geschickte Anordnung der Abschirmelemente können diese in besonders wirksamer Weise und zu einem besonders hohen Grad das Störmagnetfeld abschirmen.

Um eine besonders gute Abschirmwirkung zu erzielen, kann wenigstens eines bzw. können insbesondere alle Zusatz-Abschirmelemente auf der dem Unterbrechungsspalt gegenüberliegenden Seite angeordnet sein. Wenigstens eines der Zusatz-Abschirmelemente kann auf der dem Zentrum des verzerrten Störfeldes in Bezug auf das Abschirmelement mit Unterbrechungsspalt abgewandten Seite angeordnet sein. Diese Zusatz-Abschirmelemente können in vorteilhafter Weise dazu verwendet werden, den Sensorkopf in unmittelbarer Nähe abzuschirmen. Sie schirmen das Störfeld daher in dem Raumbereich ab, in welchem es bereits durch das den Leiter umgebende Abschirmelement mit Spalt abgeschwächt ist.

Ferner kann die Abschirmung dadurch noch verbessert werden, dass das als Platte bzw. im Wesentlichen ebene Abschirmelement zwischen Unterbrechungsspalt und dem topfförmigen Abschirmelement angeordnet wird. Auf diese Art und Weise bildet das als Platte ausgebildete bzw. ebene Abschirmelement für das Feld zunächst eine Barriere, die einen abgeschirmten Raumbereich auf der dem Zentrum des Störfeldes abgewandten Seite bewirkt. Dabei läuft ein Großteil der Feldlinien in die Randbereiche der Platte bzw. des ebenen Abschirmelementes ein. Ein in Bezug auf den Leiter bzw. den Unterbrechungsspalt auf der abgewandten Seite der Platte bzw. des ebenen Abschirmelementes angeordneter Sensorkopf wird somit bereits wesentlich von Bereichen mit hoher Feldstärke abgeschirmt.

Im Anschluss daran kann der Bereich hinter der Platte bzw. dem ebenen Element, wo auch der Sensorkopf platziert werden kann, wenigstens teilweise vom topfförmigen Zusatz-Abschirmelement umgeben sein. Die offene Seite des topförmigen Elementes kann der Platte bzw. dem ebenen Abschirmelement zugewandt sein, sodass z.B. ein fast vollständig vom Zusatz-Abschirmelement umgebener und nur an einzelnen Stellen offener Bereich entsteht.

Dadurch, dass die einzelnen Abschirmelemente räumlich getrennt voneinander angeordnet sind und auch nicht magnetisch leitend miteinander verbunden werden, können sich in diesen auch keine in sich geschlossenen Feldlinien ausbilden, sodass die Abschirmwirkung wiederum erhöht wird. An den Unterbrechungsstellen, also den Plattenrändern und den Rändern des Topfes bilden sich entsprechend Bereiche hoher magnetischer Feldstärke / Flussdichte, nicht jedoch im Inneren des somit durch Platte und Topf abgegrenzten Bereichs, in dem der Sensorkopf möglichst gut geschirmt angeordnet werden soll.

Bei einer weiteren Ausführungsform der Erfindung kann die Sensorvorrichtung das topförmige Abschirmelement wenigstens teilweise durchsetzen. Insbesondere kann die Sensorvorrichtung wenigstens teilweise auf der vom elektrischen Leiter abgewandten Seite des Topfes angeordnet sein. Je nach Größe der Sensorvorrichtung ist es gegebenenfalls nicht zweckmäßig, die Abschirmvorrichtung so auszubilden, dass tatsächlich die gesamte Sensorvorrichtung, zum Beispiel einschließlich der Steuer- und Auswerteelektronik abgeschirmt wird, insbesondere, wenn diese Teile keiner besonders starken Abschirmung bedürfen. In vorteilhafter Weise wird jedoch ermöglicht, dass die restliche Sensorvorrichtung unmittelbar mit dem Sensorkopf verbunden sein kann. Auf diese Weise kann insbesondere der benötigte Bauraum möglichst verringert werden.

Um das Störfeld wiederum zu vermessen, kann im Unterbrechungsspalt ein Sensor zur Bestimmung der magnetischen Feldstärke bzw. der magnetischen Flussdichte angebracht werden. Beispielsweise kann hierfür ein Hall-Sensor eingesetzt werden. Durch die Anordnung mit dem Unterbrechungsspalt kann dieser Sensor so platziert werden, dass er keinen zu hohen magnetischen Feldstärken / Flussdichten ausgesetzt ist, da sich das Zentrum des Störfeldes in Richtung Unterbrechungsspalt verschiebt. Durch die vorgegebene Geometrie ist aber der prinzipielle Verlauf der Feldlinien relativ genau bekannt, sodass bei einer derartigen Anordnung, insbesondere bei einer Anordnung im Bereich des Unterbrechungsspaltes sehr genau berechenbar ist, bei welchen Stromstärken, mit denen der Leiter durchflossen wird, welche Feldstärke in diesem Bereich zu erwarten ist. Grundsätzlich kann der Sensor aber auch an einer anderen Stelle positioniert werden, um zum Beispiel zu Bereichen höherer Feldstärke zu gelangen, beispielsweise indem er näher an Randbereiche des Abschirmelements verschoben wird.

Bei der Sensorvorrichtung handelt es sich um eine solche, mit der ein Nutzfeld in Form eines Magnetfelds, insbesondere eines sich ändernden Magnetfelds bestimmt wird. Dieses sich ändernde Magnetfeld wird durch eine Maß-Verkörperung, zum Beispiel einen drehbar gelagerten Magnetrotor hervorgerufen . Diese erzeugt sodann ein magnetisches Nutzfeld, das mit der Sensorvorrichtung vermessen werden soll.

Bei einer Ausführungsform kann der Magnetrotor mit aufgebrachtem Elastomer NBR eingesetzt werden, um eine präzise Magnetisierung und ein flexibles Montieren zu ermöglichen. Anstelle eines solchen Magnetrotors kann grundsätzlich auch ein Zahnrad verwendet werden.

Damit jedoch das Nutzfeld selbst zumindest nicht vor der Sensorvorrichtung bzw. dem Sensorkopf abgeschirmt wird, wird die Maß-Verkörperung außerhalb des als Rahmen bzw. Hohlkörper ausgebildeten Abschirmelements angeordnet sein. Des Weiteren kann die Maß-Verkörperung bei der Weiterbildung der Erfindung wenigstens teilweise zwischen zwei der Zusatz-Abschirmelemente verlaufen, sodass ihr Magnetfeld in Bezug auf den Sensorkopf nicht abgeschirmt wird, etwa zwischen der Platte bzw. dem ebenen Abschirmelement und dem topfförmigen Abschirmelement. Die Maß-Verkörperung kann also grundsätzlich in den inneren Bereich gelangen, der von den Zusatz-Abschirmelementen geschirmt wird. Um ferner den benötigten Bauraum möglichst gering zu halten, kann die Maß-Verkörperung den elektrischen Leiter bzw. das als Rahmen oder Hohlkörper ausgebildete Abschirmelement wenigstens teilweise, insbesondere vollständig umgeben. Durch diese Art der Ausgestaltung wird vom Sensorkopf gewissermaßen nur das im Bereich des Sensorkopfs erzeugte Magnetfeld des gesamten Nutzfeldes detektiert.

Bei einer besonders bevorzugten Weiterbildung der Erfindung ist die elektrische Baueinheit als Modul ausgebildet, um als Ganzes verbaut werden zu können. Diese Ausgestaltung bietet insbesondere den Vorteil, dass auch dann, wenn die Baueinheit grundsätzlich zwei funktional unterschiedliche Bauteile umfasst, diese aber dennoch zusammen in einer kompakten Baueinheit angeordnet und implementiert sind, dass eine wirksame Abschirmung des von einem der Bauteile erzeugten Störmagnetfelds erfolgt. Müssten die beiden funktional unterschiedlichen Bauteile getrennt eingebaut werden, hätte dies den Nachteil, dass die Abschirmung je nach Anordnung eigens neu entworfen werden müsste. Dies würde die Konstruktion gegebenenfalls stark verteuern. Die kompakte elektronische Baueinheit kann also in vorteilhafter Weise in der Regel ohne größere Anpassungen an die technische Umgebung verbaut werden.

### Ausführungsbeispiel:

Ein Ausführungsbeispiel der Erfindung ist in den Zeichnungen dargestellt und wird nachstehend unter Angabe weiterer Einzelheiten und Vorteile näher erläutert.

Im Einzelnen zeigen:
- Fig. 1:: eine schematische Darstellung einer elektrischen Baueinheit gemäß der Erfindung,
- Fig. 2:: eine schematische Draufsicht auf die Baueinheit (mit Magnetrotor) gemäß Figur 1 einschließlich einer Darstellung der Feldverteilung,
- Fig. 3:: eine schematische Darstellung eines geraden Leiters mit vollständig den Leiter umgebender Abschirmung und Feldverteilung,
- Fig. 4:: eine schematische Darstellung des Leiters aus Figur 3 mit unterbrochener Abschirmung und Feldverteilung,
- Fig. 5:: eine schematische Darstellung der Abschirmung durch eine Platte als einziges Abschirmelement,
- Fig. 6:: eine schematische Darstellung der Abschirmung durch ein topfförmiges Element als einziges Abschirmelement,
- Fig. 7:: eine schematische Darstellung der Abschirmung einer Kombination aus topfförmigen Element und Platte mit Darstellung der Feldverteilung, sowie
- Fig. 8:: eine schematische Darstellung der Abschirmung durch eine Kombination von Abschirmelementen gemäß der Erfindung.

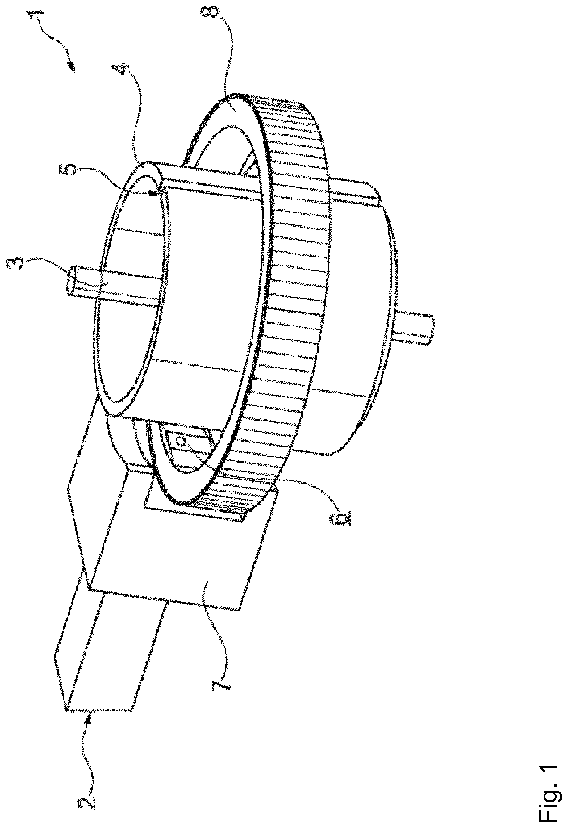

Eine elektrische Baueinheit 1 gemäß der Erfindung ist in Figur 1 in Schrägansicht dargestellt. Diese Baueinheit 1 umfasst zunächst eine Sensorvorrichtung 2, ein elektrischen Leiter 3, ein Abschirmelement 4 mit Unterbrechungsspalt 5 und zwei Zusatz-Abschirmelemente 6, 7, nämlich eine Platte 6 und ein topfförmiges Abschirmelement 7. Diese Abschirmelemente 4-7 bilden die Abschirmvorrichtung. Zudem ist ein Magnetrotor 8 vorgesehen, der pro Winkelsegment mit Permanentmagneten ausgestattet ist und gegenüber der Sensorvorrichtung 2 drehbar gelagert ist.

Durch die sensorische Erfassung des sich bei Rotation des Magnetrotor 8 wechselnden Magnetfelds kann somit die Umdrehungszahl bestimmt werden, sodass die Baueinheit 1 unter anderem die Funktion eines Drehgebers, etwa im Eisenbahnbereich erfüllen kann. Der Magnetrotor 8 dient dabei als Maß-Verkörperung, d.h. der Magnetrotor 8 dreht sich mit der gleichen Winkelgeschwindigkeit wie zum Beispiel ein Rad eines Zuges, sodass mithilfe des Drehgebers die Fahrgeschwindigkeit ermittelt werden kann. Der Magnetrotor 8 ist dabei so angeordnet, dass er in den Bereich zwischen Platte 6 und topfförmiges Abschirmelement 7 eingreift bzw. durch diesen Bereich durchfährt. Der Magnetrotor 8 ist außerdem so angeordnet, dass er sowohl den Leiter 3 als auch das mit einem Spalt 5 versehene Abschirmelement 4 umgibt.

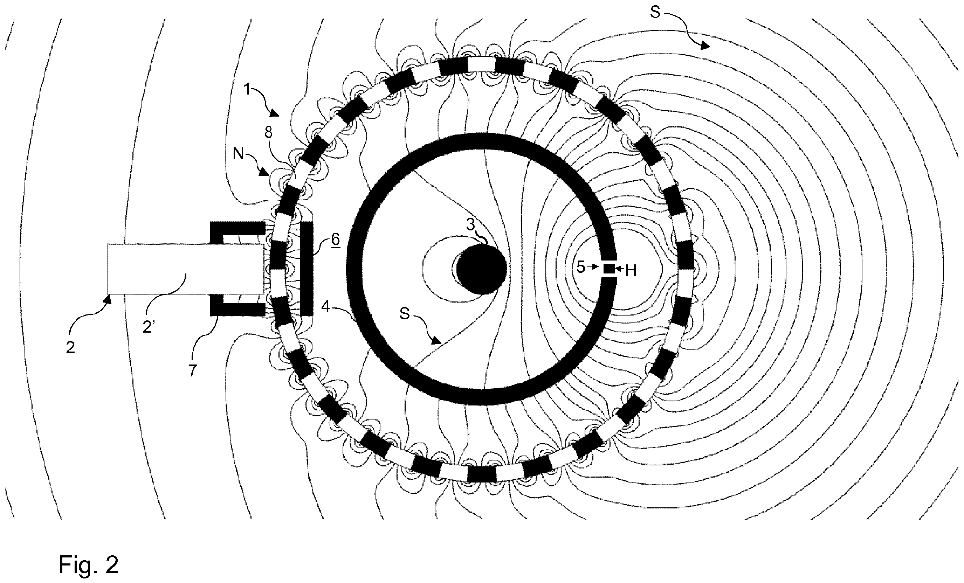

Die Sensorvorrichtung 2 ist insgesamt nicht vollständig in dem topfförmigen Element 7 untergebracht. Vielmehr weist das topfförmige Element 7 an der dem Leiter 3 abgewandten Seite eine Öffnung auf, durch welche die Sensorvorrichtung 2 hindurchgeführt wird, sodass der eigentliche Sensorkopf 2', mit dem das vom Magnetrotor 8 erzeugte Nutzfeld vermessen wird (vgl. Figur 2).

Bei dem Sensorkopf 2' kann es sich insbesondere um einen AMR-Sensor handeln (AMR: anisotroper Magnetowiderstand).

Figur 2 wiederum zeigt eine schematische Draufsicht auf die elektrische Baueinheit 1 aus Figur 1 einschließlich der mit ihr erreichten Feldverteilung. Zunächst ist in Figur 2 ein Schnitt durch die bereits genannten Komponenten der elektrischen Baueinheit 1 dargestellt, umfassend die Sensorvorrichtung 2 mit dem Sensorkopf 2', das topfförmige Abschirmelement 7, durch dessen Rückseite/Boden die Sensorvorrichtung 2 hindurch gesteckt wurde, die Platte 6, das Abschirmungselement 4 mit dem Unterbrechungsspalt 5, sowie den Magnetrotor 8 und den Leiter 3, der senkrecht zur Zeichenebene in Figur 2 steht und gerade verläuft. Der Leiter 3 bildet einen Teil der Baueinheit 1 und dient hier im Grunde lediglich als Leitung bzw. Teil der Stromversorgung eines größeren Aggregats, in diesem Fall des Zuges. Da dieser Leiter 3 von einem starken Strom durchflossen wird, hier in der Größenordnung von 1500 A, wird durch ihn ein nicht zu vernachlässigendes magnetisches Störfeld erzeugt. Im Falle einer Stromversorgung für einen Zug (Erdbürste), die an den Leiter 3 angeschlossen wird, fließt in der Regel ein Gleichstrom oder aber ein sehr niederfrequenter Wechselstrom von ca. 16,6 Hz oder 50Hz.

Die Feldverteilung des Störfeldes S ist ebenfalls in Figur 2 dargestellt. Dabei ist jedoch zu beachten, dass sich grundsätzlich das vom geraden Leiter 3 erzeugte Störfeld aus kreisförmigen Feldlinien zusammensetzen würde, wenn es nicht durch die Abschirmelemente 4, 5, 6, 7 vor allem das Abschirmelement 4, 5 beeinflusst würde. Darüber hinaus überlagert sich das Störfeld S mit dem Nutzfeld N, welches vom Magnetrotor 8 erzeugt wird; zu sehen ist dies insbesondere im Zwischenbereich zwischen dem Abschirmelement 4 und dem Magnetrotor 8.

Zudem ist im Spalt 5 zur Bestimmung der Stromstärke im Leiter 3 ein Hall-Sensor H angeordnet, der die magnetische Feldstärke misst und mit dessen Messergebnissen die Stromstärke errechnet werden kann.

Das vom Magnetrotor 8 erzeugte Wechselfeld N wird vom Sensorkopf 2' detektiert, und zwar im geschirmten Raumbereich zwischen dem topfförmigen Abschirmelement 7 und der Platte 6.

Die zunächst grundlegende Abschirmung erfolgt jedoch durch das Abschirmelement 4 mit dem Spalt 5. Wie bereits oben erläutert, ist zunächst grundsätzlich zu erwarten, dass die Feldlinien des Störfeldes als konzentrische Kreise um den Leiter 3 auftreten. Dieses durch den Leiter 3 erzeugte Feld wird jedoch durch das Abschirmelement 4 verzerrt, und es wird insgesamt in Figur 2 in Bezug auf sein Zentrum von der Sensorvorrichtung 2 Weg verschoben. Bereits durch diese Verzerrung und Verschiebung wird die Sensorvorrichtung 2 grundsätzlich vor dem durch den Leiter 3 erzeugten Störfeld S geschirmt bzw. das Störfeld wird so verändert, dass die Sensorvorrichtung 2 im Bereich eines Minimums liegt.

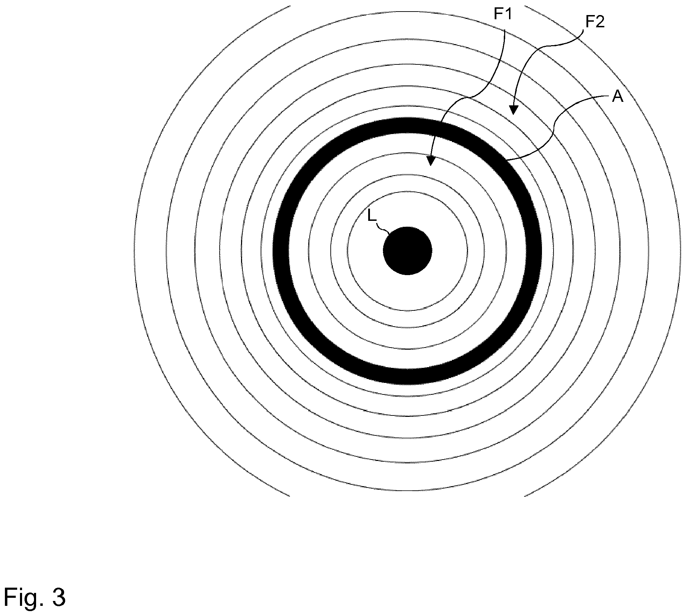

Figur 3 zeigt erläutert, welchen Effekt ein Abschirmelement A auf das Feld eines geraden Leiters L haben würde, wenn das Abschirmelement A den Leiter L um seine Achse herum vollständig umgäbe. Da es keine magnetischen Monopole gibt, handelt es sich bei Magnetfeldern grundsätzlich um sog. quellenfreie Felder, deren Feldlinien geschlossen sind. Der magnetische Kraftfluss durch eine geschlossene Oberfläche ist Null. Bei einem idealen geraden Leiter L umgeben die Feldlinien den Leiter als konzentrische Kreise, wie dies zunächst im Bereich F1 in Figur 3 der Fall ist. Sie können die Oberfläche des Abschirmelements aber nicht durchsetzen, und es erfolgt keine Abschirmung nach außen hin, sodass im Bereich F2 immer noch ein magnetisches Feld mit konzentrischen Feldlinien die Eigenschaften des Raumes beeinflusst.

Ist das Abschirmelement aus einem magnetisch leitfähigen Material µ gefertigt, besitzt es eine hohe magnetische Permeabilität, was z.B. bei ferromagnetischen Materialien (relative Permeabilität µᵣ >> 1) gegeben ist.

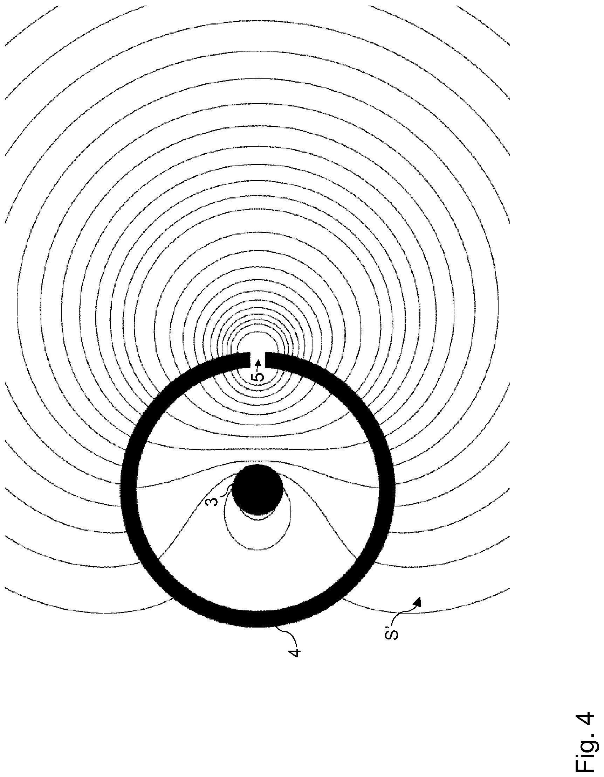

Anders verhält sich der Abschirmungseffekt bei einer Anordnung gemäß Figur 4, denn das Abschirmelement 4 umgibt den Leiter 3 bis auf den Bereich des Spaltes 5. Das Störfeld S' wird gegenüber der Situation in Figur 3 nicht nur verzerrt, sondern sein Zentrum liegt nicht mehr im Inneren des Leiters 3 (betrachtet in der Schnittdarstellung, in welcher der Leiter 3 senkrecht zur Zeichenebene gemäß Figur 4 angeordnet ist) bzw. vielmehr seitlich in Richtung des Spaltes 5 versetzt ist. Im Inneren des Abschirmelements 4 herrscht eine relativ hohe Feldliniendichte auf der Seite des Leiters 3, die dem Spalt 5 zugewandt ist. Der dem Spalt 5 bzw. dem Zentrum des neuen Störfeldes S' Bereich wird also in Bezug auf das magnetische Störfeld S' stärker abgeschirmt, als dies zuvor in Figur 3 der Fall war.

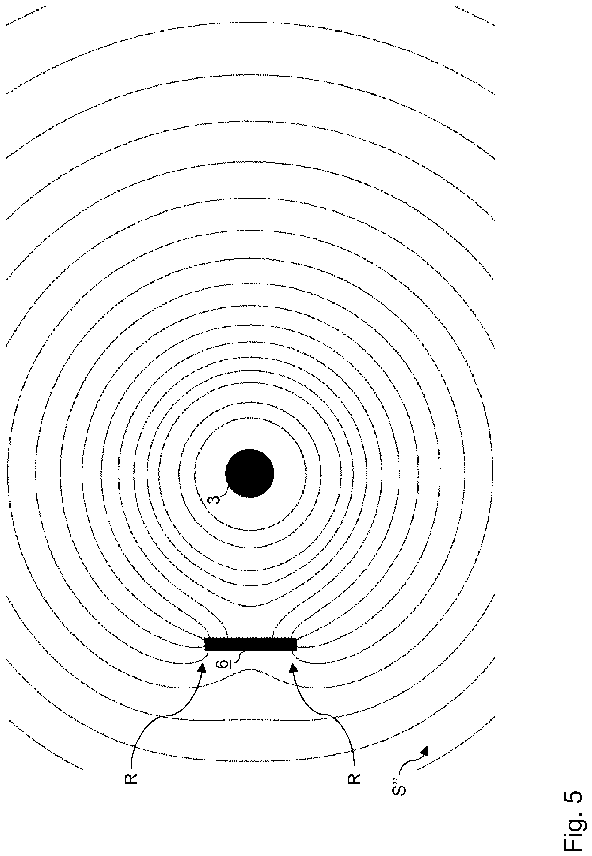

In Figur 5 ist dargestellt, welche Wirkung die Platte 6 für sich alleine als Abschirmelement in Bezug auf ein vom Leiter 3 erzeugtes magnetisches Störfeld S". Das Feld S" wird durch die Anwesenheit des magnetisch leitfähigen Abschirmelementes 6 in Form einer Platte vor allem im Bereich der Platte 6 verzerrt. Das Zentrum des Feldes S" befindet sich jedoch weiterhin in der Ebene senkrecht zur Erstreckungsrichtung des Leiters 3 hier im Leiter 3 selbst. Auf der gegenüber dem Leiter 3 der Platte 6 abgewandten Seite ist die Störung des Feldes S" in Figur 5 vergleichsweise gering, sodass sich die Form der Feldlinien an konzentrisch verlaufende Kreisbögen um den Leiter 3 herum annähert. Die Feldlinien durchsetzen jedoch im Wesentlichen senkrecht vor allem die Randbereiche R der Platte 6. Hierdurch wird vor allem der dem Leiter 3 abgewandte Bereich hinter der Platte 6 geschirmt, und diese Position eignet sich daher grundsätzlich zur dortigen Anordnung eines Sensors, welcher magnetisch geschirmt werden soll.

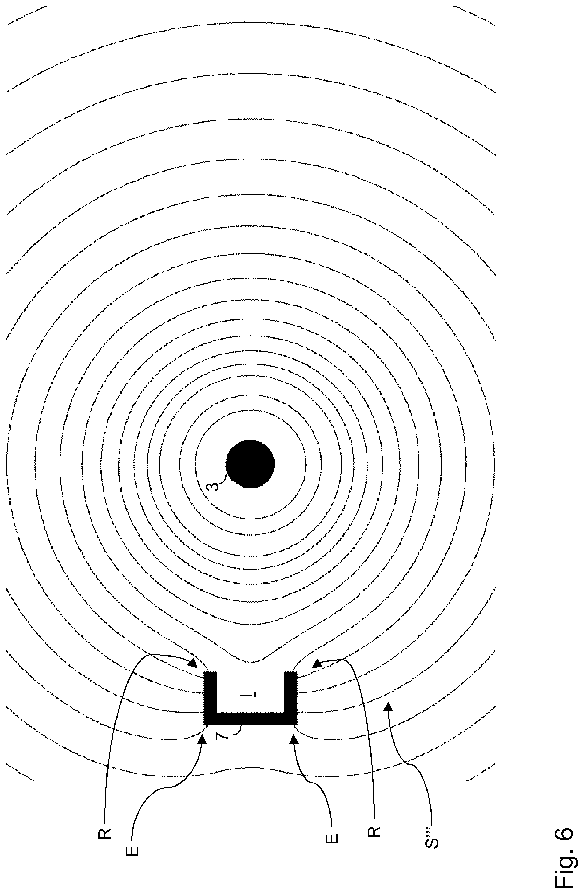

Die Änderung des durch den Leiter 3 hervorgerufenen Magnetfelds S'" durch ein topfförmiges Abschirmelement 7 ist in Figur 6 zu sehen. Bei der gewählten Anordnung des Abschirmelements 7 gegenüber dem Leiter 3 ist das Feld S'" im Bereich des topfförmiges Elementes 7 verzerrt. Auf der dem topfförmigen Element 7 abgewandten Seite des Leiters 3 nähern sich die Feldlinien wiederum der Form konzentrischer Kreisbögen an. Auch bei einem Topf förmigen Element 7 ist eine Konzentration der Feldlinien in den Rand- bzw. Eckbereichen des topfförmigen Elements zu verzeichnen, wobei die Feldlinien im Wesentlichen senkrecht in die Oberfläche des Abschirmelements 7 laufen. Geschirmt wird somit zwar auch, wie in Figur 5, der dem Leiter 3 abgewandte Bereich des Topf förmigen Elementes 7, vor allem jedoch der Innenbereich I des Topf förmigen Elements.

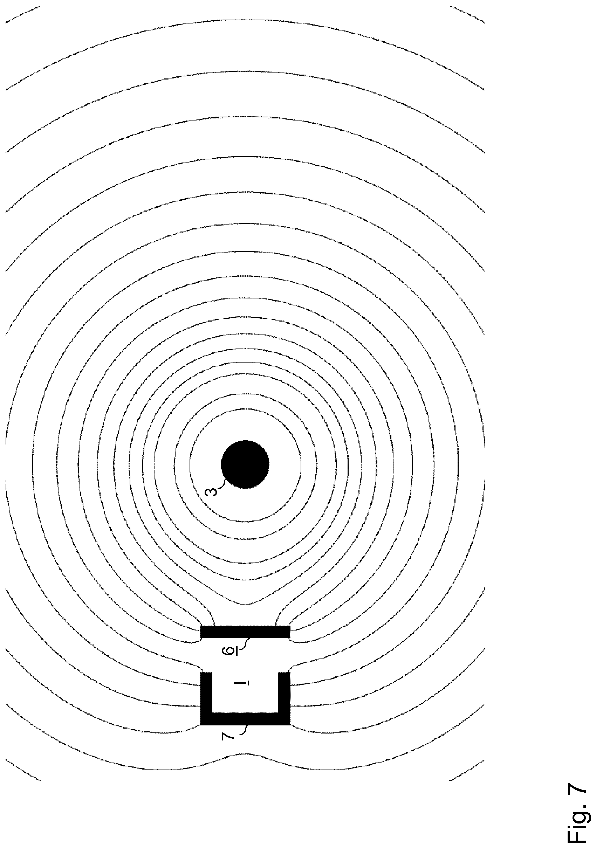

Figur 7 zeigt daher eine vorteilhafte Kombination der beiden abschirmen Elemente 6, 7 aus den Figuren 5 und 6. Hier wird der Innenbereich I gegenüber dem Feld, das von dem geraden, in Figur 7 senkrecht zur Zeichenebene stehenden Leiter 3 erzeugt wird, abgeschirmt.

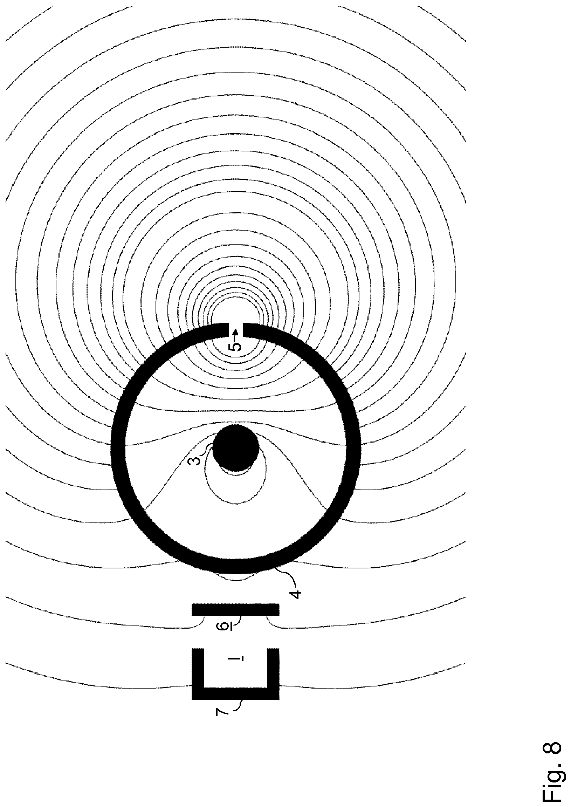

Um diese Abschirmungswirkung noch weiter verbessern zu können, wird gemäß einer besonders bevorzugten Ausführungsform der Erfindung eine Anordnung gemäß Figur 8 gewählt. Hier wird der Leiter 3 zunächst von einem Abschirmelement 4 umgeben, wobei das Abschirmelement 4 jedoch durch einen Spalt 5 unterbrochen ist. Hierdurch tritt die bereits in Figur 4 dargestellte Verzerrung des Störfeldes auf, die zudem mit einer Verlagerung des Zentrums des Störfeldes in Richtung des Spaltes 5 einhergeht. Das Störfeld besitzt also ein Minimum auf der dem Unterbrechungsspalt 5 gegenüber dem Leiter 3 abgewandten Seite. Im Raumbereich dieses Minimums des Magnetfeldes, das als Störfeld auftritt, wird sodann die in Figur 7 gezeigte Anordnung von Zusatz-Abschirmelementen 6, 7 positioniert, d.h. das bereits durch das Abschirmelement 4 in diesem Raumbereich geschwächte Magnetfeld wird noch einmal durch die beiden ZusatzElemente 6, 7 weiter abgeschwächt. Im somit gebildeten Innenraum I dieser Zusatz-Abschirmelemente 6, 7 kann somit in vorteilhafter Weise der Sensorkopf 2' angeordnet werden, und mit ihm zusammen der Erzeuger des zu vermessenden Nutzfeldes, hier der Magnetrotor 8, wie es in den Figuren 1 und 2 dargestellt ist.

Allen Ausführungsformen und Weiterbildung der Erfindung ist somit gemeinsam, dass zu einer effektiven Abschirmung die Abschirmvorrichtung ein als Rahmen bzw. Hohlkörper ausgebildetes Abschirmelement aus einem magnetisch leitfähigen Material umfasst, das den elektrischen Leiter wenigstens auf einem Teil der Länge, insbesondere über die gesamte Länge des elektrischen Leiters in einer Ebene senkrecht zur Stromflussrichtung bis auf ein Unterbrechungsspalt umgibt, um das Störfeld zu verzerren und/oder zu verschieben.

## Patentansprüche

1. Elektrische Baueinheit (1), umfassend:
- eine Sensorvorrichtung (2) zum sensorischen Erfassen einer Messgröße, mit einem Sensorkopf (2') zur Erfassung einer magnetischen und/oder elektrischen Messgröße;
- wenigstens einen elektrischen Leiter (3) zur Leitung von elektrischem Strom;
- eine Abschirmvorrichtung (4, 5, 6, 7) zur Abschirmung der Sensorvorrichtung (2) und/oder des Sensorkopfes (2') vor dem Magnetfeld, das durch den elektrischen Stromfluss durch den wenigstens einen elektrischen Leiter (3) erzeugt wird und als Störfeld (S) hinsichtlich des Sensorkopfes wirkt,
- wobei die Abschirmvorrichtung (4, 5, 6, 7) ein als Rahmen und/oder Hohlkörper ausgebildetes Abschirmelement (4) aus einem magnetisch leitfähigen Material umfasst, das den elektrischen Leiter (3) wenigstens auf einem Teil der Länge des wenigstens einen elektrischen Leiters (3) in einer Ebene nahezu senkrecht zur Stromflussrichtung bis auf einen Unterbrechungsspalt (5) umgibt, um das Störfeld (S) zu verzerren und/oder zu verschieben; wobei
eine Maß-Verkörperung (8) vorgesehen ist, welche
- dazu ausgebildet ist, ein magnetisches Nutzfeld (N) zu erzeugen, um dieses mit der Sensorvorrichtung (2, 2') zu vermessen;
- drehbar gelagert ist;
- außerhalb des als Rahmen und/oder Hohlkörper ausgebildeten Abschirmelements (4) angeordnet ist und den wenigstens einen elektrischen Leiter (3) und/oder das als Rahmen und/oder Hohlkörper ausgebildete Abschirmelement (4) umgibt, wobei
- die Sensorvorrichtung (2) und der Sensorkopf (2') im Bereich eines Minimums der magnetischen Flussdichte des durch die Abschirmvorrichtung (4, 5, 6, 7) verzerrten und verschobenen Störfelds (S) und auf der dem Unterbrechungsspalt (5) abgewandten Seite angeordnet ist/sind.

2. Elektrische Baueinheit (1) nach Anspruch 1, **dadurch gekennzeichnet, dass** die Maß-Verkörperung (8) als ein Magnetrotor oder ein Zahnrad ausgebildet ist.

3. Elektrische Baueinheit (1) nach einem der vorgenannten Ansprüche, **dadurch gekennzeichnet, dass** die Abschirmvorrichtung wenigstens ein Zusatz-Abschirmelement (6, 7) umfasst, welches:
- als Platte und/oder im Wesentlichen ebenes Abschirmelement (6) ausgebildet ist und/oder
- als topfförmiges Abschirmelement (7) ausgebildet ist, das im Inneren (I) einen abzuschirmenden Bereich in einer Ebene umgibt und zu einer Seite hin wenigstens teilweise, insbesondere vollständig begrenzt.

4. Elektrische Baueinheit (1) nach einem der vorgenannten Ansprüche, **dadurch gekennzeichnet, dass** wenigstens zwei, insbesondere alle Abschirmelemente einschließlich der Zusatz-Abschirmelemente (4, 5, 6, 7) magnetisch voneinander isoliert sind.

5. Elektrische Baueinheit (1) nach einem der vorgenannten Ansprüche, **dadurch gekennzeichnet, dass** wenigstens eines der, insbesondere alle Zusatz-Abschirmelemente (6, 7) auf der dem Unterbrechungsspalt (5) gegenüber dem wenigstens einen elektrischen Leiter (3) abgewandten Seite oder im Bereich eines Minimums der magnetischen Flussdichte angeordnet ist/sind.

6. Elektrische Baueinheit (1) nach einem der vorgenannten Ansprüche, **dadurch gekennzeichnet, dass** das als Platte und/oder im Wesentlichen ebenes Abschirmelement (6) zwischen dem Unterbrechungsspalt (5) und dem topfförmigen Abschirmelement (7) auf der dem Unterbrechungsspalt gegenüber dem wenigstens einen elektrischen Leiter (3) abgewandten Seite angeordnet ist.

7. Elektrische Baueinheit (1) nach einem der vorgenannten Ansprüche, **dadurch gekennzeichnet, dass** das topfförmige Abschirmelement (7) mit der offenen Seite dem elektrischen Leiter (3) und/oder dem als Rahmen und/oder Hohlkörper ausgebildeten Abschirmelement (4) zugewandt ist.

8. Elektrische Baueinheit (1) nach einem der vorgenannten Ansprüche, **dadurch gekennzeichnet, dass** die Sensorvorrichtung (2) einen Sensorkopf (2') umfasst, der wenigstens teilweise, insbesondere vollständig im Inneren (I) des topfförmigen Abschirmelements (7) angeordnet ist/sind.

9. Elektrische Baueinheit (1) nach einem der vorgenannten Ansprüche, **dadurch gekennzeichnet, dass** die Sensorvorrichtung (2) das topfförmige Abschirmelement (7) wenigstens teilweise durchsetzt und/oder wenigstens teilweise auf der vom wenigstens einen elektrischen Leiter (3) abgewandten Seite des topfförmigen Abschirmelements (7) angeordnet ist.

10. Elektrische Baueinheit (1) nach einem der vorgenannten Ansprüche, **dadurch gekennzeichnet, dass** im Unterbrechungsspalt (5) ein Sensor (H) zur Bestimmung der magnetischen Feldstärke und/oder der magnetischen Flussdichte, insbesondere ein Hall-Sensor angeordnet ist, um den elektrischen Strom zu vermessen.

11. Elektrische Baueinheit (1) nach einem der vorgenannten Ansprüche, **dadurch gekennzeichnet, dass** die Maß-Verkörperung (8) wenigstens teilweise zwischen zwei der Zusatz-Abschirmelemente (6, 7) angeordnet ist.

12. Elektrische Baueinheit (1) nach einem der vorgenannten Ansprüche, **dadurch gekennzeichnet, dass** die Maß-Verkörperung (8) in den inneren, von den Zusatz-Abschirmelementen (6, 7) abgeschirmten Bereich (I) eingreift und/oder im inneren, von den Zusatz-Abschirmelementen (6, 7) abgeschirmten Bereich (I) angeordnet ist.

## Claims

1. Electrical unit (1), comprising:
- a sensor device (2) for the sensory acquisition of a measured variable, with a sensor head (2') for the acquisition of a magnetic and/or electrical measured variable;
- at least one electrical conductor (3) for conducting electrical current;
- a shielding device (4, 5, 6, 7) for shielding the sensor device (2) and/or the sensor head (2') against the magnetic field which is generated by the electrical current flow by means of the at least one electrical conductor (3) and acts as an interference field (S) with regard to the sensor head,
- the shielding device (4, 5, 6, 7) comprising a shielding element (4) designed as a frame and/or a hollow body made of a magnetically conductive material, surrounding the electrical conductor (3) over at least one part of the length of the at least one electrical conductor (3) in a plane nearly perpendicular to the direction of the current flow up to an interrupter gap (5) in order to distort and/or shift the interference field (S); wherein
a material measure (8) is provided which
- is designed to generate a magnetic working field (N) in order to measure it with the sensor device (2, 2');
- is rotatably pivoted;
- is arranged outside of the shielding element (4) designed as a frame and/or a hollow body and which surrounds the at least one electrical conductor (3) and/or the shielding element (4) designed as a frame and/or a hollow body, wherein
- the sensor device (2) and the sensor head (2') is/are arranged within the area of a minimum of the magnetic flux density of the interference field (S) distorted and shifted by means of the shielding device (4, 5, 6, 7) and on the side facing away from the interrupter gap (5).

2. Electrical unit (1) according to claim 1, **characterized in that** the material measure (8) is designed as a magnetic rotor or as a gear wheel.

3. Electrical unit (1) as claimed in any of the aforementioned claims, **characterized in that** the shielding device comprises at least one supplementary shielding element (6, 7) which
- is designed as a plate and/or as an essentially planar shielding element (6), and/or
- is designed as a pot-shaped shielding element (7) which, on the inside (I), encloses a shieldable area in a plane and restricts it, towards one side, at least partly, particularly completely.

4. Electrical unit (1) as claimed in any of the aforementioned claims, **characterized in that** at least two, particularly all shielding elements - including the supplementary shielding elements (4, 5, 6, 7) - are magnetically isolated from each other.

5. Electrical unit (1) as claimed in any of the aforementioned claims, **characterized in that** at least one of the supplementary shielding elements - particularly all supplementary shielding elements (6, 7) - is/are arranged on the side facing away from the at least one electrical conductor (3) vis-à-vis the interrupter gap (5) or in the area of a minimum of the magnetic flux density.

6. Electrical unit (1) as claimed in any of the aforementioned claims, **characterized in that** the shielding element designed as a plate and/or as an essentially planar shielding element (6) between the interrupter gap (5) and the pot-shaped shielding element (7) is arranged vis-à-vis the interrupter gap, on the side facing away from the at least one electrical conductor (3).

7. Electrical unit (1) as claimed in any of the aforementioned claims, **characterized in that** the pot-shaped shielding element (7) - with its open side - is facing the electrical conductor (3) and/or the shielding element (4) designed as a frame and/or a hollow body.

8. Electrical unit (1) as claimed in any of the aforementioned claims, **characterized in that** the sensor device (2) comprises a sensor head (2') being arranged, at least partly, especially completely on the inside (I) of the pot-shaped shielding element (7).

9. Electrical unit (1) as claimed in any of the aforementioned claims, **characterized in that** the sensor device (2) at least partly enters the pot-shaped shielding element (7) and/or is at least partly arranged on the side of the pot-shaped shielding element (7) facing away from the at least one electrical conductor (3).

10. Electrical unit (1) as claimed in any of the aforementioned claims, **characterized in that** a sensor (H) is arranged - especially a Hall sensor - in the interrupter gap (5) to measure the electrical current by determining the magnetic field strength and/or the magnetic flux density.

11. Electrical unit (1) as claimed in any of the aforementioned claims, **characterized in that** the material measure (8) is arranged at least partly between two of the supplementary shielding elements (6, 7).

12. Electrical unit (1) as claimed in any of the aforementioned claims, **characterized in that** the material measure (8) engages in the inner area (I) shielded by the supplementary shielding elements (6, 7) and/or is arranged in the inner area (I) shielded by the supplementary shielding elements (6, 7).

## Revendications

1. Module électrique (1) comprenant :
- un dispositif de détection (2) destiné à détecter de manière sensorielle une grandeur de mesure, avec une tête de détection (2') destinée à détecter une grandeur de mesure magnétique et/ou électrique ;
- au moins un conducteur électrique (3) destiné à conduire le courant électrique ;
- un dispositif de blindage (4, 5, 6, 7) destiné à blinder le dispositif de détection (2) et/ou la tête de détection (2') contre le champ magnétique, qui est généré par le flux de courant électrique à travers le au moins un conducteur électrique (3) et agit comme champ perturbateur (S) par rapport à la tête de détection,
- le dispositif de blindage (4, 5, 6, 7) comprenant un élément de blindage (4) se présentant sous la forme d'un cadre et/ou d'un corps creux dans un matériau conducteur magnétique, qui entoure le conducteur électrique (3) au moins sur une partie de la longueur du au moins un conducteur électrique (3) dans un plan presque perpendiculaire au sens du flux du courant jusqu'à un entrefer d'interruption (5), pour déformer et/ou déplacer le champ perturbateur (S) ;
un étalon de mesure (8) étant prévu, lequel
- est conçu pour générer un champ magnétique efficace (N) pour mesurer celui-ci avec le dispositif de détection (2, 2') ;
- est monté rotatif ;
- est disposé à l'extérieur de l'élément de blindage (4) se présentant sous la forme d'un cadre et/ou d'un corps creux et entoure le au moins un conducteur électrique (3) et/ou l'élément de blindage (4) se présentant sous la forme d'un cadre et/ou d'un corps creux,
- le dispositif de détection (2) et la tête de détection (2') étant disposés dans la zone d'une valeur minimale d'induction magnétique du champ perturbateur (S) déformé et déplacé par le dispositif de blindage (4, 5, 6, 7) et sur le côté opposé à l'entrefer d'interruption (5).

2. Module électrique (1) selon la revendication 1, **caractérisé en ce que** l'étalon de mesure (8) se présente sous la forme d'un rotor magnétique ou d'une roue dentée.

3. Module électrique (1) selon l'une des revendications précédentes, **caractérisé en ce que** le dispositif de blindage comprend au moins un élément de blindage supplémentaire (6, 7) qui :
- se présente sous la forme d'une plaque et/ou d'un élément de blindage essentiellement plan (6) et/ou
- se présente sous la forme d'un élément de blindage en forme de pot (7) qui entoure dans l'espace intérieur (I) une zone à blinder dans un plan et la délimite vers un côté au moins en partie, en particulier entièrement.

4. Module électrique (1) selon l'une des revendications précédentes, **caractérisé en ce qu'**au moins deux, en particulier tous les éléments de blindage y compris les éléments de blindage supplémentaires (4, 5, 6, 7) sont isolés magnétiquement les uns des autres.

5. Module électrique (1) selon l'une des revendications précédentes, **caractérisé en ce qu'**au moins un des éléments de blindage supplémentaires (6, 7), en particulier tous, sont disposés sur le côté opposé à l'entrefer d'interruption (5) par rapport au au moins un conducteur électrique (3) ou dans une zone d'une valeur minimale de l'induction magnétique.

6. Module électrique (1) selon l'une des revendications précédentes, **caractérisé en ce que** l'élément de blindage (6) se présentant sous la forme d'une plaque et/ou essentiellement plan entre l'entrefer d'interruption (5) et l'élément de blindage en forme de pot (7) est disposé sur le côté opposé à l'entrefer d'interruption par rapport au au moins un conducteur électrique (3).

7. Module électrique (1) selon l'une des revendications précédentes, **caractérisé en ce que** l'élément de blindage en forme de pot (7) avec le côté ouvert est tourné vers le conducteur électrique (3) et/ou à l'élément de blindage (4) se présentant sous la forme d'un cadre et/ou d'un corps creux.

8. Module électrique (1) selon l'une des revendications précédentes, **caractérisé en ce que** le dispositif de détection (2) comprend une tête de détection (2'), qui est disposée au moins en partie, en particulier entièrement dans l'espace intérieur (I) de l'élément de blindage en forme de pot (7).

9. Module électrique (1) selon l'une des revendications précédentes, **caractérisé en ce que** le dispositif de détection (2) introduit au moins partiellement l'élément de blindage en forme de pot (7) et/ou est disposé au moins partiellement sur le côté de l'élément de blindage en forme de pot (7) détourné du au moins un conducteur électrique (3).

10. Module électrique (1) selon l'une des revendications précédentes, **caractérisé en ce qu'**un capteur (H) destiné à déterminer la grandeur de champ magnétique et/ou l'induction magnétique, en particulier un capteur à effet Hall, est disposé dans l'entrefer d'interruption (5) pour mesurer le courant électrique.

11. Module électrique (1) selon l'une des revendications précédentes, **caractérisé en ce que** l'étalon de mesure (8) est disposé au moins en partie entre deux des éléments de blindage supplémentaires (6, 7).

12. Module électrique (1) selon l'une des revendications précédentes, **caractérisé en ce que** l'étalon de mesure (8) s'insère dans l'espace intérieur (I) blindé par les éléments de blindage supplémentaires (6, 7) et/ou est disposé dans l'espace intérieur (I) blindé par les éléments de blindage supplémentaires (6, 7).
